(19) Europäisches Patentamt
European Patent Office
Office européen des brevets

(11) **EP 1 901 425 B1**

(12) **EUROPEAN PATENT SPECIFICATION**

(45) Date of publication and mention
of the grant of the patent:
**08.08.2018 Bulletin 2018/32**

(51) Int Cl.:
***H03F 1/48*** *(2006.01)* ***H03F 3/45*** *(2006.01)*

(21) Application number: **06019088.1**

(22) Date of filing: **12.09.2006**

(54) **Amplifier with increased bandwidth and method thereof**

Verstärker mit vergrösserter Bandbreite und Verfahren dazu

Amplificateur avec une largeur de bande augmentée et procédé associé

(84) Designated Contracting States:
**DE GB**

(43) Date of publication of application:
**19.03.2008 Bulletin 2008/12**

(73) Proprietor: **Realtek Semiconductor Corp.**
**Hsinchu 300 (TW)**

(72) Inventor: **Tu, Chuan Ping**
**Hsin Chu City (TW)**

(74) Representative: **Ter Meer Steinmeister & Partner**
**Patentanwälte mbB**
**Nymphenburger Straße 4**
**80335 München (DE)**

(56) References cited:
WO-A1-97/03496 US-A1- 2003 001 075
US-A1- 2005 017 797 US-A1- 2005 162 232
US-B1- 6 353 361 US-B1- 6 380 806
US-B2- 7 116 172

• **DURHAM A M ET AL: "HIGH-LINEARITY**
**CONTINUOUS-TIME FILTER IN 5-V VLSI CMOS"**
**IEEE JOURNAL OF SOLID-STATE CIRCUITS,**
**IEEE SERVICE CENTER, PISCATAWAY, NJ, US,**
**vol. 27, no. 9, 1 September 1992 (1992-09-01),**
**pages 1270-1276, XP000311191 ISSN: 0018-9200**
• **HUANG K-C ET AL: "A Low Voltage-Power 13-Bit**
**16 MSPS CMOS Pipelined ADC", IEEE JOURNAL**
**OF SOLID-STATE CIRCUITS, IEEE SERVICE**
**CENTER, PISCATAWAY, NJ, USA, vol. 39, no. 5,**
**1 May 2004 (2004-05-01), pages 834-836,**
**XP011111821, ISSN: 0018-9200, DOI:**
**10.1109/JSSC.2004.826344**

**EP 1 901 425 B1**

**Description**

Background of Invention

1. Field of the Invention

The present invention relates to an amplifier, and more particularly, to an amplifier with increased bandwidth by current injection.

2. Description of the Prior Art

Operational amplifiers are one of the most widely used structures in modern day engineering. They can have many applications ranging from buffers and filters to analog-to-digital converters. Where high performance is required, such as a high speed, high resolution analog-to-digital converter, an operational amplifier having both high gain and high bandwidth is necessary.

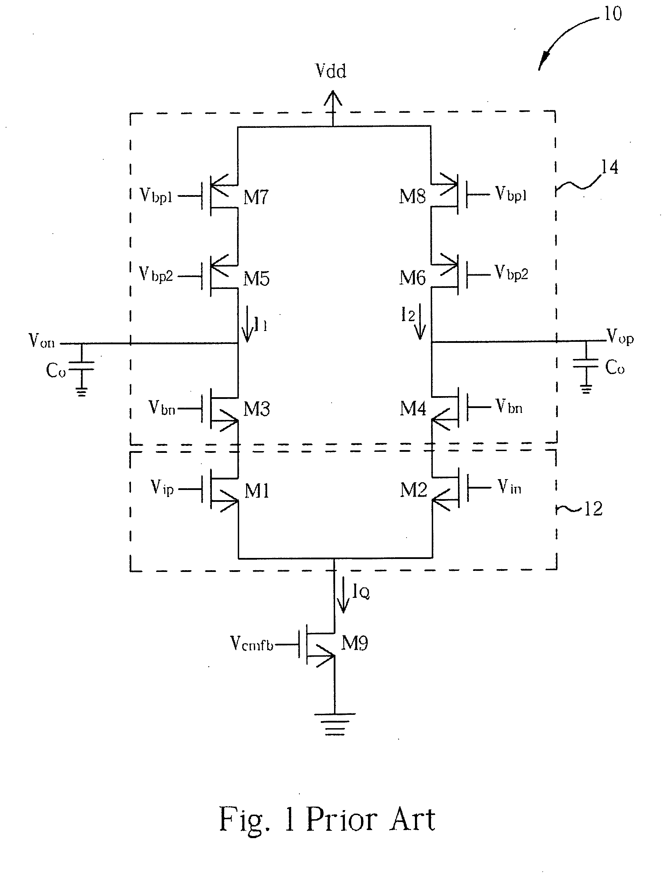

Please refer to Fig.1. Fig.1 shows a conventional telescopic operational amplifier 10. It comprises a plurality of transistors M1-M9. Matched transistors M1 and M2 serve as an input stage 12 for respectively receiving a non-inverting input $V_{ip}$ and an inverting input $V_{in}$, while transistors M3-M8 biased by voltages $V_{bn}$, $V_{bp1}$, $V_{bp2}$ act as a load stage 14 (i.e., an active load). The remaining transistor M9 is biased by voltage $V_{cmfb}$, and is the tail transistor acting as a current source for sinking a constant reference current $I_Q$, thereby steering the currents $I_1$ and $I_2$. Since transistors M5 and M6 are a matched pair and transistors M7 and M8 are a matched pair, currents $I_1$ and $I_2$ therefore have the same current value. If both transistors M1 and M2 are turned on, $I_1$ is equal to half $I_Q$, and $I_1$ is equal to $I_2$. As shown in Fig.1, both the non-inverting output $V_{on}$ and the inverting output $V_{op}$ are coupled to an output capacitor $C_0$. A telescopic configuration is often a preferred configuration because telescopic operational amplifiers consume less power than other topologies. They also have the added advantage of high speed. The telescopic configuration is well known to those skilled in the art, and therefore is not described in detail here.

The frequency response of an operational amplifier is the response of the circuit in the frequency domain.

In other words, if the circuit is given a sinusoidal input the response should be a sinusoidal output of the same frequency, but amplified by the open loop gain, $A_0$. This frequency response can be modeled as a low pass function.

$$H(s) = \frac{A_0}{1 + \dfrac{s}{\omega_p}} \quad \text{where } \omega_p \text{ is the dominate pole and } s = j\omega \qquad \text{Equation (1)}$$

For frequencies much greater than $\omega_p$, i.e. $\omega \gg \omega_p$, we can approximate the gain, A, to be:

$$A(j\omega) = \frac{A_0 \omega_p}{j\omega} \qquad\qquad \text{Equation (2)}$$

$$\left| A(j\omega) \right| = \frac{A_0 \omega_p}{\omega} \qquad\qquad \text{Equation (3)}$$

Therefore, putting this result back into equation (1), we can obtain the unity-gain bandwidth $\omega_u$:

$$\omega_u = A_0 \omega_p \qquad\qquad \text{Equation (4)}$$

The unity gain bandwidth can also be written in terms of device transconductance, gm, and output resistance, $r_0$. Equation (4) then becomes:

$$\omega_u = \frac{gm \times r_0}{r_0 C_0} = \frac{gm}{C_{op} + C_{load}}$$
$$\text{Equation (5)}$$

From equation (5) it can be seen that the unity gain bandwidth $\omega_u$ is a function of device transconductance gm, and total output capacitance $C_0$. The total output capacitance includes parasitic junction capacitance $C_{op}$, and capacitive load $C_{load}$ driven by the operational amplifier 10. Therefore, the way to increase bandwidth is by increasing gm or by decreasing the output capacitance $C_0$. $C_{load}$ cannot be decreased because it is determined by circuit specification and hence cannot be decreased for a specific application. Furthermore, the parasitic capacitance dominates the capacitive load, so decreasing $C_{load}$ would only have a minimal effect. To increase gm would require a larger device, which then leads to more parasitic capacitance, as the device size cannot be increased without limits. This gain-bandwidth relation therefore creates an upper level bandwidth limit.

US 2005/0017797 A1 describes a switched capacitor feedback circuit including two or more input ports configured to receive a corresponding a number of input signals and at least one output port. The output port is configured to output an adjusting signal. The input signals includes a number of primary signals and two or more reference signals that are associated with a first timing phase of operation. The adjusting signal is produced based upon a comparison between the primary signals the reference signals. Also provided is a pair of active devices having gates coupled together and structured to receive the adjusting signal. The active devices are configured to provide a gain to the adjusting signal in accordance with a predetermined gain factor, and facilitate an adjustment to the number of primary signals based upon the gain during a second timing phase of operation.

US 2003/0001075 A2 describes an analog circuit including an amplifier with a positive input node, a negative input node, a positive output node and a negative output node. A first capacitor is coupled between the negative input node and an analog signal node. A second capacitor is coupled between the positive input node and a reference voltage node. In addition, a third capacitor is coupled between the positive input node and the negative output node and a fourth capacitor is coupled between the negative input node and the positive output node. A first switch is coupled between the third capacitor and the negative output node and a second switch is coupled between the fourth capacitor and the positive output node.

US 6,380,806 B1 describes a fully differential telescopic operational amplifier having a switch capacitor common mode feedback (CMFB) circuit portion. The switched capacitor CMFB circuit portion has a current mirror for mirroring current from a first transistor to a second transistor. The first and second transistors have gates which are coupled via a transmission gate switch. Drains of each of the first and second transistors are respectively coupled to a first and a second differential pair of transistors, each differential pair connected to receive a common mode voltage and drains of the first differential pair connected to the gate of the first transistor. The first and second differential pair are scaled with respect to each other such that the gate to source voltage of the first transistor is substantially equal to the gate to source voltage of the second transistor.

HUANG K-C et al: "A Low Voltage-Power 13-Bit 16 MSPS CMOS Pipelined ADC", IEEE JOURNAL OF SOLID-STATE CIRCUITS, IEEE SERVICE CENTER, PISCATAWAY, NJ, USA, vol. 39, No. 5, 1 May 2004, pages 834-836, XP011111821, ISSN: 0018-9200, DOI: 10.1109/JSSC.2004.826344, describes an operational transconductance amplifier with five cascoded transistors. A gain enhancement amplifier with dc level shifting for wide-swing approaching is adopted that consists of twelve first transistors and twelve second transistors.

Summary of Invention

It is therefore one of the objectives of the claimed invention to provide an amplifier with increased bandwidth by current injection and a related method thereof.

It is therefore one of the objectives of the claimed invention to provide an amplifier. The amplifier with current injection has an increased bandwidth while maintaining a high gain.

It is therefore one of the objectives of the claimed invention to provide an amplifier. The amplifier does not require increased power consumption or circuit area.

The objects are solved by the features of the independent claims.

These and other objectives of the present invention will no doubt become obvious to those of ordinary skill in the art after reading the following detailed description of the preferred embodiment that is illustrated in the various figures and drawings.

Brief Description of Drawings

Fig.1 is a diagram illustrating a conventional telescopic operational amplifier.
Fig.2 is a diagram of a telescopic operational amplifier according to a first embodiment of the present invention.
Fig.3 is a diagram of a telescopic operational amplifier according to a second embodiment of the present invention.

Detailed Description

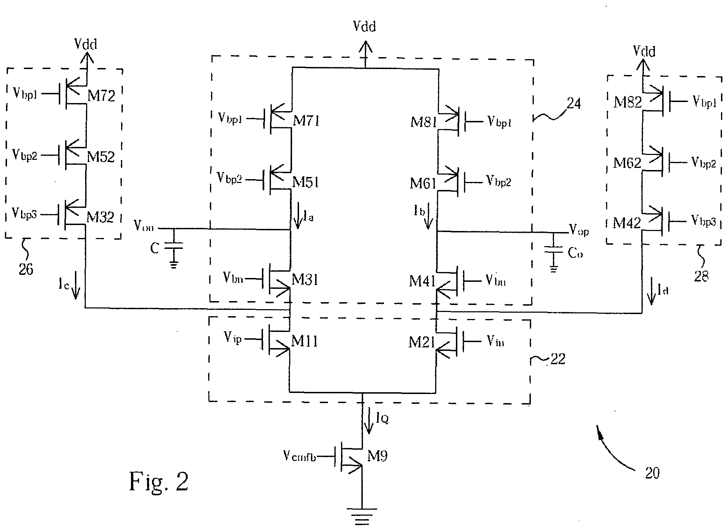

Please refer to Fig.2. Fig.2 is a diagram of a telescopic operational amplifier 20 with current injection according to a first embodiment of the present invention, for increasing the bandwidth while maintaining a high gain. The telescopic operational amplifier 20 includes an input stage 22, which has two transistors M1 and M2, and a load stage 24, which has a plurality of transistors M31, M41, M51, M61, M71, M81. The transistor M9 acts as a current source for sinking a constant reference current $I_Q$, thereby steering the currents $I_a$-$I_d$. If both transistors M1 and M2 are turned on, the collective currents $I_{a\ and}\ I_c$ are equal to the current $I_1$ shown in Fig.1, and the collective currents $I_{b\ and}\ I_d$ are equal to the current $I_2$ shown in Fig.1. Please note that the circuit architecture of the input stage 22 and load stage 24 is substantially the same as that of the input stage 12 and load stage 14 shown in Fig.1. The amplifier 20 of the present invention further comprises extra current sources 26 and 28.
As shown in Fig.2, a series of electrically connected transistors M72, M52 and M32 are coupled to the drain of the transistor M1, and a series of electrically connected transistors M82, M62 and M42 are coupled to the drain of the transistor M2, for respectively injecting a current $I_c$ and a current $I_d$ into the input stage 22. The transistors M72 and M82 are biased by a voltage $V_{bp1}$, M52 and M62 are biased by a voltage $V_{bp2}$, and M32 and M42 are biased by a voltage $V_{bp3}$. Additionally, an inverting output $V_{on}$ coupled to an output capacitor $C_0$ is coupled to the drain of the transistor M31 and an non-inverting output $V_{op}$ coupled to an output capacitor $C_0$ is coupled to the drain of the transistor M41. Transistors M32, M42, M51, M52, M61, M62, M71, M72, M81, M82 are PMOS transistors, and transistors M1, M2, M9, M31, M41 are NMOS transistors. Both of the current sources 26, and 28 are p-type current sources. Since the transistor M9 still sinks the reference current $I_Q$, the original currents $I_1$, $I_2$ shown in Fig.1 are changed due to the injected currents $I_c$, $I_d$. In order to maintain the same bias condition, the size of the devices is scaled, according to the change of current of each device. Assume that $I_a$ is set to $k*I_1$. Therefore, the channel aspect ratio (W/L) is adjusted accordingly. In other words, for transistor M71 as compared to transistor M7 in Fig. 1, the channel aspect ratio is:

$$\left(\frac{W}{L}\right)_{M71} = k * \left(\frac{W}{L}\right)_{M7} \qquad \text{where } 0 < k < 1 \qquad \text{Equation (6)}$$

Similarly, for transistor M81 as compared to transistor M8 in Fig. 1:

$$\left(\frac{W}{L}\right)_{M81} = (1-k) * \left(\frac{W}{L}\right)_{M8} \qquad \text{where } 0 < k < 1 \qquad \text{Equation (7)}$$

The frequency response for the operational amplifier 20 can still be modeled as a lowpass function as shown by equation (1). The dominate pole $\omega_p$, however, is now:

$$\omega_p = \frac{1}{r_0 C_0} = \frac{1}{r_0\left(kC_{op} + C_{load}\right)} \qquad \text{Equation (8)}$$

This is because the device size has decreased by a factor of k, where $0 < k < 1$, and therefore the parasitic capacitance $C_{op}$ has also decreased by a factor of k.
Putting this result in the equation for unity-gain bandwidth $\omega_u$ it can be shown that:

$$\omega_u = \frac{gm \times r_0}{r_0 C_0} = \frac{gm}{r_0\left(kC_{op} + C_{load}\right)} \qquad \text{Equation (9)}$$

Due to the smaller device parasitic capacitance $C_{OP}$, the unity-gain bandwidth $\omega_u$, compared with the prior art unity-gain bandwidth, has been increased by a factor:

$(C_{op} + C_{load})/(kC_{op} + C_{load})$. Please note that the circuit size of the operational amplifier 20 is substantially the same as that of the operational amplifier 10 shown in Fig.1.

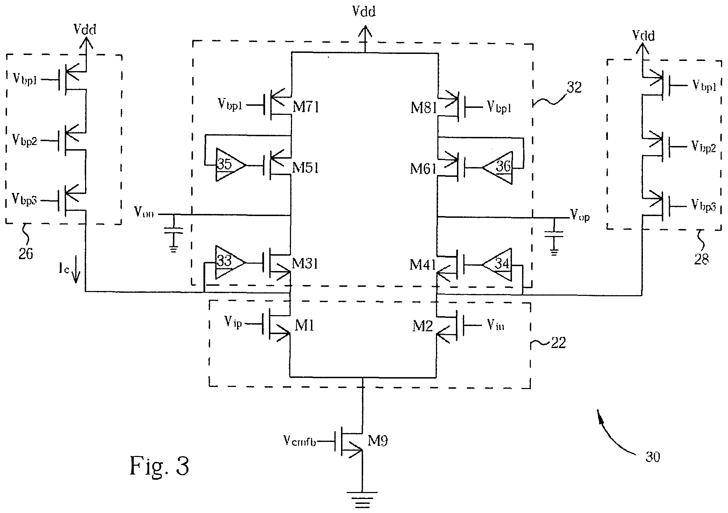

Please refer to Fig.3. Fig.3 is a diagram of a telescopic operational amplifier 30, with gain boosting and current injection, according to a second embodiment of the present invention, for increasing the bandwidth while also increasing the gain. The telescopic operational amplifier 30 is similar to the above telescopic operational amplifier 20. The lengthy description of the same components, i.e., the transistor M9, the input stage 22 and the current sources 26, 28, is not repeated. As shown in Fig.3, the key difference is that the telescopic operational amplifier 30 has a load stage 32 including a plurality of amplifiers 33, 34, 35, 36 used to enable the gain boosting. Since the gain boosting is well known to those skilled in this art, further description is omitted for brevity. Compared with the telescopic operational amplifier 20, the telescopic operational amplifier 30 has an increased DC gain $A_0$ due to the gain boosting. In addition, with the currents injected into the input stage 22 by the current sources 26 and 28, the bandwidth of the operational amplifier 30 is thereby increased.

Please note that, in the above-mentioned embodiments, the current injection is applied to a differential pair.

The embodiments of the present invention have an increased bandwidth without sacrificing gain. The circuit area and power consumed are still approximately the same but the parasitic capacitance has been decreased. The current injection technique can also be used in a gain boosted operational amplifier, therefore allowing both the bandwidth and the gain to be increased at the same time.

Those skilled in the art will readily observe that numerous modifications and alterations of the device and method may be made while retaining the teachings of the invention. Accordingly, the above disclosure should be construed as limited only by the metes and bounds of the appended claims.

**Claims**

1. An amplifier comprising:

   an input stage (22) comprising a first NMOS transistor (M1) for receiving a first input signal ($V_{in}$) inputted into the gate of the first NMOS transistor, and a second NMOS transistor (M2) for receiving the second input signal ($V_{ip}$) inputted into the gate of the second NMOS transistor;
   a load stage (24, 32) coupled between the input stage (22) and a predetermined voltage ($V_{dd}$), the load stage (24, 32) is an active load of electrically coupled in cascade transistors (M31, M41, M51, M61, M71, M81) comprising a plurality of electrically coupled third transistors (M31, M51, M71) coupled to the first NMOS transistor (M1) of the input stage (22) for generating the first output signal ($V_{op}$) and a plurality of electrically coupled fourth transistors (M41, M61, M81) coupled to the second NMOS transistor (M2) of the input stage (22) for generating the second output signal ($V_{on}$),
   a first current source (M9) coupled to the input stage (22) for allowing a predetermined current $I_Q$ to flow;
   a second current source (26, 28) coupled to the first NMOS transistor (M1) of the input stage (22) and the predetermined voltage ($V_{dd}$), wherein the second current source (26, 28) is adapted to inject a first current into the input stage (22),
   a third current source (26, 28) coupled to the second NMOS transistor (M2) of the input stage (22) and the predetermined voltage ($V_{dd}$), the third current source (26, 28) is adapted to inject a second current into the input stage (22), wherein the second and third current sources (26, 28) are coupled in parallel to the load stage (24, 32) between the predetermined voltage ($V_{dd}$) and the input stage (22),
   wherein the input stage (22), the load stage (24, 32), and the first current source (M9) are configured in a telescopic topology,
   wherein the second current source (26, 28) is a p-type current source comprising a first series of electrically connected transistors (M72; M52; M32), a drain of one transistor (M32) of said series being directly coupled to the drain of the first NMOS transistor (M1) of the input stage for injecting the first current into the drain of the first NMOS transistor, and
   wherein the third current source (26, 28) is a p-type current source comprising a series of electrically connected transistors (M82; M62; M42), a drain of one transistor (M42) of said series being directly coupled to the drain of the second NMOS transistor (M2) of the input stage for injecting the second current into the drain of the second NMOS transistor, so that transistors (M71, M81) of the load stage (24, 32) have a reduced size and reduced parasitic capacitance for achieving an increased unity-gain bandwidth for the amplifier.

2. The amplifier of claim 1, wherein the load stage (24) further comprises:
   at least an additional amplifier (33, 34, 35, 36) coupled to two nodes of a predetermined transistor from among the transistors (M31, M41, M51, M61, M71, M81) of the load stage (24).

3. The amplifier of claim 2, wherein the predetermined transistor has the source and the gate coupled to the additional amplifier (33, 34, 35, 36).

4. A method for increasing the bandwidth of an amplifier, comprising:

providing the amplifier (20, 30) with an input stage (22) for receiving a first input signal, a load stage (24, 32) for outputting a first output signal, and a first current source (M9) for allowing a predetermined current to flow; providing a second current source (26, 28) coupled in parallel to the load stage (24, 32) and injecting a first current generated by the second current source (26, 28) into the input stage (22) of the amplifier (20, 30) wherein the load stage (24, 32) is an active load comprising a plurality of electrically coupled in cascade transistors (M31, M41, M51, M61, M71, M81),

wherein the input stage (22) receives a second input signal,
wherein the load stage (24, 32) outputs a second output signal,
the method further comprising:
providing the amplifier (20, 30) with a third current source (26, 28) coupled in parallel to the load stage (24, 32), the third current source (26, 28) injects a second current into the input stage (22) of the amplifier (20, 30), wherein the input stage (22) comprises:

a first NMOS transistor (M1) for receiving the first input signal inputted into the gate of the first NMOS transistor, the drain of the first NMOS transistor being coupled to the second current source (26); and
a second NMOS transistor (M2) for receiving the second input signal inputted into the gate of the second NMOS transistor, the drain of the second NMOS transistor being coupled to the third current source (28);
the load stage (24, 32) comprises:

a plurality of electrically coupled third transistors (M31, M51, M71) coupled to the first NMOS transistor (M1) for generating the first output signal; and
a plurality of electrically coupled fourth transistors (M41, M61, M81) coupled to the second NMOS transistor (M2) for generating the second output signal; wherein the input stage (22), the load stage (24, 32), and the first current source (M9) are configured in a telescopic topology;
wherein the second current source (26, 28) is a p-type current source comprising a first series of electrically connected transistors (M72; M52; M32), a drain of one transistor (M32) of said series being directly coupled to the drain of the first NMOS transistor (M1) of the input stage for injecting the first current into the drain of the first NMOS transistor, and
wherein the third current source (26, 28) is a p-type current source comprising a series of electrically connected transistors (M82; M62; M42), a drain of one transistor (M42) of said series being directly coupled to the drain of the second NMOS transistor (M2) of the input stage for injecting the second current into the drain of the second NMOS transistor, so that transistors (M71, M81) of the load stage (24, 32) have a reduced size and reduced parasitic capacitance for achieving an increased unity-gain bandwidth for the amplifier.

5. The method of claim 4, wherein the first current source (M9) is a n-type current source.

6. The method of claim 4, wherein the step of providing the amplifier further comprises:
providing the load stage (24, 32) with at least an additional amplifier (33, 34, 35, 36) coupled to two nodes of a predetermined transistor from among the transistors (M31, M41, M51, M61, M71, M81) of the load stage (24, 32).

7. The method of claim 6, wherein the predetermined transistor having the source and the gate coupled to the additional amplifier (33, 34, 35, 36).

8. An apparatus for amplifying a first input signal to generate a first output signal, the apparatus comprising: an amplifier (20, 30) as claimed in one of the claims 1 to 3.

**Patentansprüche**

1. Verstärker, der Folgendes umfasst:

   eine Eingangsstufe (22), die einen ersten NMOS-Transistor (M1) zum Empfangen eines ersten Eingangssignals ($V_{in}$), das in das Gate des ersten NMOS-Transistors eingegeben wird, und einen zweiten NMOS-Transistor (M2) zum Empfangen des zweiten Eingangssignals ($V_{ip}$), das in das Gate des zweiten NMOS-Transistors eingegeben wird, umfasst;
   eine Laststufe (24, 32), die zwischen die Eingangsstufe (22) und eine vorgegebene Spannung ($V_{dd}$) gekoppelt ist, wobei die Laststufe (24, 32) eine aktive Last aus elektrisch gekoppelten Transistoren (M31, M41, M51, M61, M71, M81) in Kaskadenschaltung ist, die mehrere elektrisch gekoppelte dritte Transistoren (M31, M51, M71), die zum Erzeugen des ersten Ausgangssignals ($V_{op}$) an den ersten NMOS-Transistor (M1) der Eingangsstufe (22) gekoppelt sind, und mehrere elektrisch gekoppelte vierte Transistoren (M41, M61, M81), die zum Erzeugen des zweiten Ausgangssignals ($V_{on}$) an den zweiten NMOS-Transistor (M2) der Eingangsstufe (22) gekoppelt sind, umfasst,
   eine erste Stromquelle (M9), die an die Eingangsstufe (22) gekoppelt ist, um das Fließen eines vorgegebenen Stroms $I_Q$ zu ermöglichen;
   eine zweite Stromquelle (26, 28) die an den ersten NMOS-Transistor (M1) der ersten Eingangsstufe (22) und die vorgegebene Spannung ($V_{dd}$) gekoppelt ist, wobei die zweite Stromquelle (26, 28) ausgelegt ist, einen ersten Strom in die Eingangsstufe (22) einzuspeisen,
   eine dritte Stromquelle (26, 28), die an den zweiten NMOS-Transistor (M2) der Eingangsstufe (22) und die vorgegebene Spannung ($V_{dd}$) gekoppelt ist, wobei die dritte Stromquelle (26, 28) ausgelegt ist, einen zweiten Strom in die Eingangsstufe (22) einzuspeisen, wobei die zweite und die dritte Stromquelle (26, 28) in Parallelschaltung zu der Laststufe (24, 32) zwischen die vorgegebene Spannung ($V_{dd}$) und die Eingangsstufe (22) gekoppelt sind, wobei
   die Eingangsstufe (22), die Laststufe (24, 32) und die erste Stromquelle (M9) in einer ausfahrbaren Topologie konfiguriert sind,
   die zweite Stromquelle (26, 28) eine Stromquelle vom p-Typ ist, die eine erste Reihe elektrisch verbundener Transistoren (M72; M52; M32) umfasst, wobei ein Drain eines Transistors (M32) der Reihe zum Einspeisen des ersten Stroms in den Drain des ersten NMOS-Transistors direkt an den Drain des ersten NMOS-Transistors (M1) der Eingangsstufe gekoppelt ist, und
   die dritte Stromquelle (26, 28) eine Stromquelle vom p-Typ ist, die eine Reihe elektrisch verbundener Transistoren (M82; M62; M42) umfasst, wobei ein Drain eines Transistors (M42) der Reihe zum Einspeisen des zweiten Stroms in den Drain des zweiten NMOS-Transistors direkt an den Drain des zweiten NMOS-Transistors (M2) der Eingangsstufe gekoppelt ist, derart, dass die Transistoren (M71, M81) der Laststufe (24, 32) eine verringerte Größe und eine verringerte parasitäre Kapazität besitzen, um eine erhöhte Einheitsverstärkungsbandbreite für den Verstärker zu erreichen.

2. Verstärker nach Anspruch 1, wobei die Laststufe (24) ferner Folgendes umfasst:
   mindestens einen zusätzlichen Verstärker (33, 34, 35, 36), der an zwei Knoten eines vorgegebenen Transistors der Transistoren (M31, M41, M51, M61, M71, M81) der Laststufe (24) gekoppelt ist.

3. Verstärker nach Anspruch 2, wobei die Source und das Gate des vorgegebenen Transistors an den zusätzlichen Verstärker (33, 34, 35, 36) gekoppelt sind.

4. Verfahren zum Erhöhen der Bandbreite eines Verstärkers, das Folgendes umfasst:

   Ausstatten des Verstärkers (20, 30) mit einer Eingangsstufe (22) zum Empfangen eines ersten Eingangssignals, einer Laststufe (24, 32) zum Ausgeben eines ersten Ausgangssignals und einer ersten Stromquelle (M9), um einen vorgegebenen Stromfluss zu ermöglichen;
   Bereitstellen einer zweiten Stromquelle (26, 28), die parallel an die Laststufe (24, 32) gekoppelt ist und einen ersten Strom, der durch die zweite Stromquelle (26, 28) erzeugt wird, in die Eingangsstufe (22) des Verstärkers (20, 30) einspeist, wobei
   die Laststufe (24, 32) eine aktive Last ist, die mehrere elektrisch in Kaskade gekoppelte Transistoren (M31, M41, M51, M61, M71, M81) umfasst,
   die Eingangsstufe (22) ein zweites Eingangssignal aufnimmt,
   die Laststufe (24, 32) ein zweites Ausgangssignal ausgibt und
   das Verfahren ferner Folgendes umfasst:

Versehen des Verstärkers (20, 30) mit einer dritten Stromquelle (26, 28), die in Parallelschaltung an die Laststufe (24, 32) gekoppelt ist, wobei die dritte Stromquelle (26, 28) einen zweiten Strom in die Eingangsstufe (22) des Verstärkers (20, 30) einspeist, wobei
die Eingangsstufe (22) Folgendes umfasst:

einen ersten NMOS-Transistor (M1) zum Empfangen des ersten Eingangssignals, das in das Gate des ersten NMOS-Transistors eingegeben wird, wobei der Drain des ersten NMOS-Transistors an die zweite Stromquelle (26) gekoppelt ist; und
einen zweiten NMOS-Transistor (M2) zum Empfangen des zweiten Eingangssignals, das in das Gate des zweiten NMOS-Transistors eingegeben wird, wobei der Drain des zweiten NMOS-Transistors an die dritte Stromquelle (28) gekoppelt ist; wobei

die Laststufe (24, 32) Folgendes umfasst:

mehrere elektrisch gekoppelte dritte Transistoren (M31, M51, M71), die zum Erzeugen des ersten Ausgangssignals an den ersten NMOS-Transistor (M1) gekoppelt sind; und
mehrere elektrisch gekoppelte vierte Transistoren (M41, M61, M81), die zum Erzeugen des zweiten Ausgangssignals an den zweiten NMOS-Transistor (M2) gekoppelt sind; wobei
die Eingangsstufe (22), die Laststufe (24, 32) und die erste Stromquelle (M9) in einer ausfahrbaren Topologie konfiguriert sind;
die zweite Stromquelle (26, 28) eine Stromquelle vom p-Typ ist, die eine erste Reihe elektrisch verbundener Transistoren (M72; M52; M32) umfasst, wobei ein Drain des Transistors (M32) der Reihe zum Einspeisen des ersten Stroms in den Drain des ersten NMOS-Transistors direkt an den Drain des ersten NMOS-Transistors (M1) der Eingangsstufe gekoppelt ist, und
die dritte Stromquelle (26, 28) eine Stromquelle vom p-Typ ist, die eine Reihe elektrisch verbundener Transistoren (M82; M62; M42) umfasst, wobei ein Drain eines Transistors (M42) der Reihe zum Einspeisen des zweiten Stroms in den Drain des zweiten NMOS-Transistors direkt an den Drain des zweiten NMOS-Transistors (M2) der Eingangsstufe gekoppelt ist, derart, dass die Transistoren (M71, M81) der Laststufe (24, 32) eine verringerte Größe und eine verringerte parasitäre Kapazität besitzen, um eine erhöhte Einheitsverstärkungsbandbreite für den Verstärker zu erreichen.

**5.** Verfahren nach Anspruch 4, wobei die erste Stromquelle (M9) eine Stromquelle vom n-Typ ist.

**6.** Verfahren nach Anspruch 4, wobei der Schritt des Ausstattens des Verstärkers ferner Folgendes umfasst:
Ausstatten der Laststufe (24, 32) mit mindestens einem zusätzlichen Verstärker (33, 34, 35, 36), der an zwei Knoten eines vorgegebenen Transistors aus den Transistoren (M31, M41, M51, M61, M71, M81) der Laststufe (24, 32) gekoppelt ist.

**7.** Verfahren nach Anspruch 6, wobei die Source und das Gate des vorgegebenen Transistors an den zusätzlichen Verstärker (33, 34, 35, 36) gekoppelt sind.

**8.** Vorrichtung zum Verstärken eines ersten Eingangssignals, um ein erstes Ausgangssignal zu erzeugen, wobei die Vorrichtung Folgendes umfasst:
einen Verstärker (20, 30) nach einem der Ansprüche 1 bis 3.

**Revendications**

**1.** Amplificateur comprenant :

un niveau d'entrée (22) comprenant un premier transistor NMOS (M1) pour recevoir un premier signal d'entrée (Vin) rentré dans la grille du premier transistor NMOS, et un deuxième transistor NMOS (M2) pour recevoir le second signal d'entrée (Vip) rentré dans la grille du deuxième transistor NMOS ;
un niveau de chargement (24,32) couplé entre le niveau d'entrée (22) et une tension prédéterminée (Vdd), le niveau de chargement (24,32) étant une charge active de transistors couplés électriquement en cascade (M31, M41, M51, M61, M71, M81) comprenant une pluralité de troisièmes transistors couplés électriquement (M31, M51, M71) couplés au premier transistor NMOS (M1) du niveau d'entrée (22) pour générer le premier signal de sortie (Vop) et une pluralité de quatrièmes transistors couplés électriquement (M41, M61, M81) couplés au deuxième transistor NMOS (M2) du niveau d'entrée (22) pour générer le second signal de sortie (Von),
une première source de courant (M9) couplée au niveau d'entrée (22) pour permettre à un courant prédéterminé IQ de circuler ;
une deuxième source de courant (26,28) couplée au premier transistor NMOS (M1) du niveau d'entrée (22) et à la tension prédéterminée (Vdd), la deuxième source de courant (26,28) étant apte à injecter un premier courant dans le niveau d'entrée (22),
une troisième source de courant (26,28) couplée au deuxième transistor NMOS (M2) du niveau d'entrée (22) et à la tension prédéterminée (Vdd), la troisième source de courant (26,28) étant apte à injecter un deuxième courant dans le niveau d'entrée (22), les deuxième et troisième sources de courant (26,28) étant couplées en parallèle au niveau de chargement (24,32) entre la tension prédéterminée (Vdd) et le niveau d'entrée (22),
le niveau d'entrée (22), le niveau de chargement (24,32) et la première source de courant (M9) étant conçus en une topologie télescopique,
la deuxième source de courant (26,28) étant une source de courant de type p comprenant une première série de transistors connectés électriquement (M72 ; M52 ; M32), un drain d'un transistor (M32) de ladite série étant couplé directement au drain du premier transistor NMOS (M1) du niveau d'entrée pour injecter le premier courant dans le drain du premier transistor NMOS (M1), et la troisième source de courant (26,28) étant une source de courant de type p comprenant une série de transistors connectés électriquement (M82 ; M62 ; M42), un drain d'un transistor (M42) étant couplé directement au drain du deuxième transistor NMOS (M2) du niveau d'entrée pour injecter le deuxième courant dans le drain du deuxième transistor NMOS, de sorte que les transistors (M71, M81) du niveau de chargement (24,32) ont une taille réduite et une capacité parasite réduite pour créer une largeur de bande à gain unitaire accrue pour l'amplificateur.

2. Amplificateur selon la revendication 1, dans lequel le niveau de chargement (24,32) comprend en outre :
au moins un amplificateur supplémentaire (33,34,35,36) couplé à deux noeuds d'un transistor prédéterminé parmi les transistors (M31, M41, M51, M61, M71, M81) du niveau de chargement (24,32).

3. Amplificateur selon la revendication 2, dans lequel le transistor prédéterminé a sa source et sa grille couplées à l'amplificateur supplémentaire (33,34,35,36).

4. Procédés d'augmentation de la largeur de bande d'un amplificateur, comprenant :

l'équipement de l'amplificateur (20,30) avec un niveau d'entrée (22) pour recevoir un premier signal d'entrée, un niveau de chargement (24,32) pour émettre un premier signal de sortie, et une première source de courant (M9) pour permettre à un courant prédéterminé de s'écouler ;
la prévision d'une deuxième source de courant (26,28) couplée en parallèle au niveau de chargement (24,32) et l'injection d'un premier courant généré par la deuxième source de courant (26,28) dans le niveau d'entrée (22) de l'amplificateur (20,30),
le niveau de chargement (24,32) étant une charge active comprenant une pluralité de transistors couplés électriquement en cascade (M31, M41, M51, M61, M71, M81),
le niveau d'entrée (22) recevant un second signal d'entrée,
le niveau de chargement (24,32) émettant un second signal de sortie,
ce procédé comprenant en outre :

l'équipement de l'amplificateur (20,30) avec une troisième source de courant (26,28) couplée en parallèle au niveau de chargement (24,32), la troisième source de courant (26,28) injectant un deuxième courant dans le niveau d'entrée (22) de l'amplificateur (20,30),
le niveau d'entrée (22) comprenant :

un premier transistor NMOS (M1) destiné à recevoir le premier signal d'entrée rentré dans la grille du premier transistor NMOS, le drain du premier transistor NMOS étant couplé à la deuxième source de courant (26,28) ;
un second transistor NMOS (M2) destiné à recevoir le second signal d'entrée rentré dans le second transistor NMOS, le drain du second transistor NMOS étant couplé à la troisième source de courant (28) ;
le niveau de chargement (24,32) comprenant :

une pluralité de troisièmes transistors couplés électriquement (M31, M51, M71) couplés au premier transistor NMOS (M1) pour générer le premier signal de sortie ; et
une pluralité de quatrièmes transistors couplés électriquement (M41, M61, M81) couplés au deuxième transistor NMOS (M2) pour générer le second signal de sortie ;

le niveau d'entrée (22), le niveau de chargement (24,32) et la première source de courant (M9) étant conçus dans une topologie télescopique ;
la deuxième source de courant (26,28) étant une source de courant de type p comprenant une première série de transistors couplés électriquement (M72, M52, M32), un drain d'un transistor (M32) de ladite série étant couplé directement au drain du premier transistor NMOS (M1) du niveau d'entrée pour injecter le premier courant dans le drain du premier transistor NMOS, et
la troisième source de courant (26,28) étant une source de courant de type p comprenant une série de transistors couplés électriquement (M82, M62, M42), un drain d'un transistor (M42) de ladite série étant couplé directement au drain du deuxième transistor NMOS (M2) du niveau d'entrée pour injecter le deuxième courant dans le drain du deuxième transistor NMOS, de sorte que les transistors (M71, M81) du niveau de chargement (24,32) ont une taille réduite et une capacité parasitaire réduite pour créer une largeur de bande à gain unitaire accrue pour l'amplificateur.

5. Procédé selon la revendication 4, dans lequel la première source de courant (M9) est une source de courant de type n.

6. Procédé selon la revendication 4, dans lequel l'étape de prévision de l'amplificateur comprend en outre :
l'équipement du niveau de chargement (24,32) avec au moins un amplificateur supplémentaire (33,34,35,36) couplé à deux noeuds d'un transistor prédéterminé parmi les transistors (M31, M41, M51, M61, M71, M81) du niveau de chargement (24,32).

7. Procédé selon la revendication 6, dans lequel le transistor prédéterminé a sa source et sa grille couplées à l'amplificateur supplémentaire (33,34,35,36).

8. Appareil destiné à l'amplification d'un premier signal d'entrée pour générer un premier signal de sortie, cet appareil comprenant :
un amplificateur (20,30) selon l'une quelconque des revendications 1 à 3.

Fig. 1 Prior Art

Fig. 2

Fig. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20050017797 A1
- US 20030001075 A2
- US 6380806 B1

**Non-patent literature cited in the description**

- A Low Voltage-Power 13-Bit 16 MSPS CMOS Pipelined ADC. **HUANG K-C et al.** IEEE JOURNAL OF SOLID-STATE CIRCUITS. IEEE SERVICE CENTER, 01 May 2004, vol. 39, 834-836